# EUROPEAN PATENT APPLICATION

(11) **EP 4 024 482 A1**
(43) Date of publication of application: **06.07.2022**
(21) Application number: 20857699.1
(22) Date of filing: 26.08.2020
(51) Int. Cl.: H01L 33/48, H01L 33/62

(54) **LIGHT-EMITTING ELEMENT MOUTNING PACKAGE AND LIGHT-EMITTING DEVICE**

(30) Priority: 28.08.2019 JP 2019155828
(71) Applicant: Kyocera Corporation, Kyoto-shi Kyoto 612-8501 (JP)
(72) Inventor: OKAWA,Yoshihide, Kyoto-shi, Kyoto 612-8501 (JP); YAMAMOTO,Sentarou, Kyoto-shi, Kyoto 612-8501 (JP); OKAMOTO,Kazuhiro, Kyoto-shi, Kyoto 612-8501 (JP); MATSUMOTO,Yuhei, Kyoto-shi, Kyoto 612-8501 (JP); NISHIMOTO,Kazuki, Kyoto-shi, Kyoto 612-8501 (JP); SUGAI,Kouichirou, Kyoto-shi, Kyoto 612-8501 (JP)
(74) Representative: Viering, Jentschura & Partner mbB Patent- und Rechtsanwälte
(86) International application number: PCT/JP2020/032131
(87) International publication number: WO 2021/039825

(57) **Abstract**

A light emitting element mounting package includes a substrate (1), an insulating layer (3), and a metal layer (5). The insulating layer (3) includes a through hole (7) penetrating in a thickness direction and is provided on the substrate (1). The metal layer (5) is disposed on the substrate (1) in at least the through hole (7), and includes a protruding portion (11) extending from the substrate (1) along an inner wall (9) of the through hole (7). The protruding portion (11) has the shape of a connected body in which metal particles (13) are connected together. The inner wall (9) of the insulating layer (3) includes, closer to the substrate (1), an inclined surface (9a) where the through hole (7) becomes wider, and the protruding portion (11) contacts the inclined surface (9a).

## Description

### Technical Field

The present disclosure relates to a light emitting element mounting package and a light emitting device.

### Background Art

In recent years, light emitting diodes (LEDs) have been used in headlights of automobiles. Light source devices that use LEDs are required to have high heat dissipation. In such a light source device, an insulating layer, for example, is provided on a metal substrate. In this case, the insulating layer has a frame shape. Furthermore, the insulating layer is made of a ceramic (see, for example, Patent Document 1).

### Prior Art Document

### Patent Literature

Patent Document 1: WO 2017/188237

### Summary

A light emitting element mounting package of the present disclosure includes a substrate, an insulating layer, and a metal layer. The insulating layer has a through hole penetrating in a thickness direction and is provided on the substrate. The metal layer is disposed on the substrate in at least the through hole and has a protruding portion that extends from the substrate along an inner wall of the through hole.

The light emitting device of the present disclosure includes a light emitting element on the metal layer of the light emitting element mounting package described above.

### Brief Description of Drawings

FIG. 1 is an exterior perspective view of a light emitting element mounting package as an example of an embodiment.
FIG. 2 is a cross-sectional view taken along line II-II in FIG. 1.
FIG. 3 is an enlarged cross-sectional view of a portion P1 in FIG. 2.
FIG. 4 is a cross-sectional view taken along line IV-IV in FIG. 2.
FIG. 5 is a cross-sectional view illustrating a modification example of the light emitting element mounting package illustrated in FIG. 2.
FIG. 6 is an enlarged cross-sectional view of a portion P2 in FIG. 5.
FIG. 7 is a cross-sectional view for explaining a variation in the width of a through hole in a height direction of the light emitting element mounting package illustrated in FIG. 2.
FIG. 8 is a cross-sectional view illustrating a modification example of the light emitting element mounting package illustrated in FIG. 2.
FIG. 9 is a cross-sectional view illustrating a modification example of the light emitting element mounting package illustrated in FIG. 8.
FIG. 10 is an enlarged cross-sectional view of a portion P3 in FIG. 9.
FIG. 11 is a cross-sectional view illustrating a modification example of the light emitting element mounting package illustrated in FIG. 9.
FIG. 12 is an enlarged cross-sectional view of a portion P4 in FIG. 11.
FIG. 13 is a cross-sectional view illustrating another aspect of the light emitting element mounting package.
FIG. 14 is a cross-sectional view illustrating yet another aspect of the light emitting element mounting package.
FIG. 15 is a cross-sectional view illustrating yet another aspect of the light emitting element mounting package.
FIG. 16 is an exterior perspective view of a light emitting device illustrated as an example of an embodiment.
FIG. 17 is a cross-sectional view taken along line XVII-XVII in FIG. 16.
FIG. 18 is a cross-sectional view illustrating a method of manufacturing a light emitting element mounting package and a light emitting device as an example of an embodiment.

### Description of Embodiments

The light emitting element mounting package disclosed in Patent Document 1 includes an insulating layer made of a ceramic on a substrate made of a metal. In this case, the substrate and the insulating layer are formed of different materials. This may lead to peeling between the substrate and the insulating layer. One cause of peeling is strain generated between the substrate and the insulating layer. The strain is caused by the different thermal expansion coefficients and Young's moduli of the substrate and the insulating layer. The substrate and the insulating layer have different thermal expansion coefficients and Young's moduli, and strain occurs due to thermal stress generated between both members.

Thus, the present disclosure provides a light emitting element mounting package and a light emitting device that are not prone to peeling between the substrate and the insulating layer.

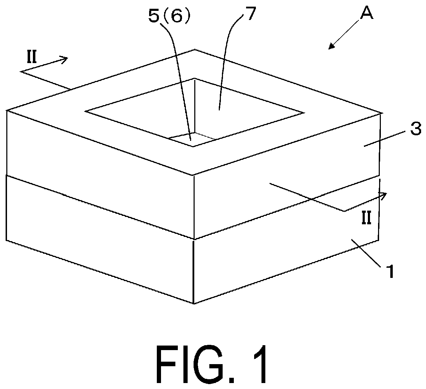

FIGS. 1 to 18 are for explaining in detail a light emitting element mounting package and a light emitting device of an embodiment. Note that the present disclosure is not limited to the specific embodiments described below. Also, an aspect of the disclosure is assumed to include various aspects, provided that these aspects fall within the spirit or scope of the general inventive concepts as defined by the appended claims.

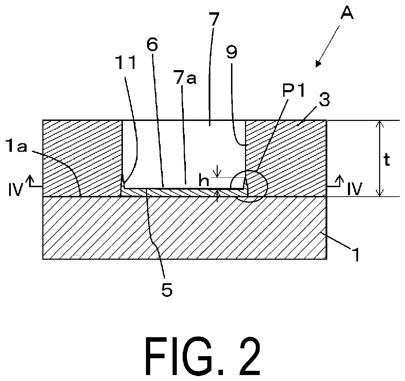

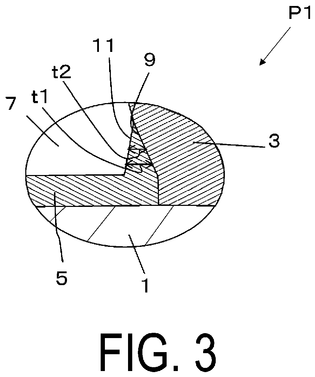

FIG. 1 is an exterior perspective view of a light emitting element mounting package as an example of an embodiment. FIG. 2 is a cross-sectional view taken along line II-II in FIG. 1. FIG. 3 is an enlarged cross-sectional view of a portion P1 in FIG. 2.

A light emitting element mounting package A illustrated as an example of an embodiment includes a substrate 1, an insulating layer 3, and a metal layer 5. The insulating layer 3 includes a through hole 7 penetrating in a thickness direction. The insulating layer 3 is disposed on the substrate 1. The structure in which the insulating layer 3 including the through hole 7 is disposed on the substrate 1 is a structure in which the insulating layer 3 forms a cavity on the substrate 1. Here, the insulating layer 3 being disposed "on" the substrate 1 is intended to include not only a case in which the insulating layer 3 is directly in contact with a surface of the substrate 1 but also a case in which the insulating layer 3 is disposed on the surface of the substrate 1 via another member. The same applies to the following case in which "on" is used.

The metal layer 5 is disposed on the substrate 1. The metal layer 5 is disposed in at least the through hole 7 on the substrate 1. The metal layer 5 is disposed on the substrate 1 so as to occupy an inner region of the through hole 7. That is, the metal layer 5 includes a portion occupying at least an inner region of the through hole 7 on the substrate 1. Furthermore, the metal layer 5 includes a portion extending from the substrate 1 along an inner wall 9 of the through hole 7. The portion of the metal layer 5 extending from the substrate 1 along the inner wall 9 of the through hole 7 is referred to as a protruding portion 11. The protruding portion 11 is provided on the metal layer 5. The protruding portion 11 has a structure growing from the metal layer 5. The protruding portion 11 also has a structure continuous from a flat portion 6. Note that in the present disclosure, a portion of the metal layer 5 along the substrate 1 is referred to as a flat portion 6.

In the light emitting element mounting package A of the present disclosure, as illustrated in FIGS. 2 and 3, the protruding portion 11, which is a portion of the metal layer 5, is adhered to the inner wall 9 of the through hole 7. The protruding portion 11 can suppress the movement of the insulating layer 3 to a center portion 7a of the through hole 7 due to thermal expansion. That is, the protruding portion 11 suppresses the movement of the insulating layer 3 on the substrate 1. The protruding portion 11 is provided so as to adhere to the inner wall 9 of the through hole 7, and thus the insulating layer 3 is unlikely to move on the substrate 1 in a direction along a surface 1a of the substrate 1. That is, the protruding portion 11 can reduce the amount of deformation between the substrate 1 and the insulating layer 3. This suppresses peeling of the insulating layer 3 from the substrate 1. Here, the surface 1a of the substrate 1 is a surface that the insulating layer 3 is in contact with.

In this case, the substrate 1 is preferably made of a metal. The insulating layer 3 is preferably made of an organic resin. The material of the substrate 1 is preferably at least one selected from the group consisting of aluminum, zinc, copper, and the like. Of these materials, when a light emitting element mounting package is applied to, for example, a headlamp of an automobile, aluminum is preferable because it is lightweight and has a high oxidation resistance.

The material of the organic resin is preferably at least one selected from the group consisting of phenol resin, amino resin, urea resin, melamine resin, polyester resin, and epoxy resin. Of these materials, epoxy resin is preferable in terms of having high heat resistance and high mechanical strength, and being relatively inexpensive. In this case, the insulating layer 3 may include an inorganic filler. When the insulating layer 3 includes an inorganic filler, the mechanical strength of the insulating layer 3 can be further increased. When the insulating layer 3 includes an inorganic filler, the thermal expansion coefficient of the insulating layer 3 can be reduced. A constitution in which the insulating layer 3 includes an inorganic filler can bring the thermal expansion coefficient of the insulating layer 3 closer to the thermal expansion coefficient of the substrate 1. The material of the inorganic filler may be at least one selected from the group consisting of silica, alumina, mullite, glass, and the like. Of these materials, silica is preferable in terms of employing a material having a small particle size and a uniform particle size.

The material (constituent) of the metal layer 5 is preferably at least one selected from the group consisting of zinc, nickel, copper, palladium, and gold. The metal layer 5 may have a structure in which these materials (constituents) overlap in layers.

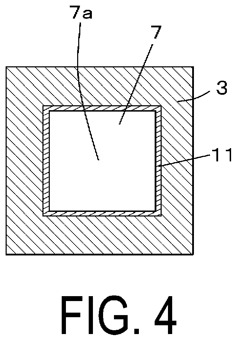

FIG. 4 is a cross-sectional view taken along line IV-IV in FIG. 2. As illustrated in FIG. 4, the protruding portion 11 is preferably provided so as to encircle the inner wall 9 of the through hole 7 provided in the insulating layer 3. Note that the protruding portion 11 is provided upright in the through hole 7 in an outer edge portion of the flat portion 6 of the metal layer 5. Here, the protruding portion 11 "encircling" the inner wall 9 of the through hole 7 refers to a state in which the protruding portion 11 is formed around the entire circumference of the inner wall 9 of the through hole 7. The protruding portion 11 encircling the inner wall 9 of the through hole 7 provided in the insulating layer 3 can suppress the movement of the insulating layer 3 on the substrate 1 from the entire circumference of the through hole 7 toward a center portion of the through hole 7. In this case, it is only required that the protruding portion 11, as illustrated in FIG. 2, have a height h that is equal to or greater than a predetermined height that can stop the movement of the insulating layer 3 toward a center of the through hole 7. The height h of the protruding portion 11 is preferably 1/100 or more and 1/5 or less of a thickness t of the insulating layer 3. Specifically, it is only required that the height h of the protruding portion 11 be 1 µm or more.

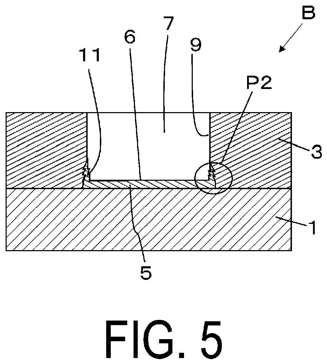

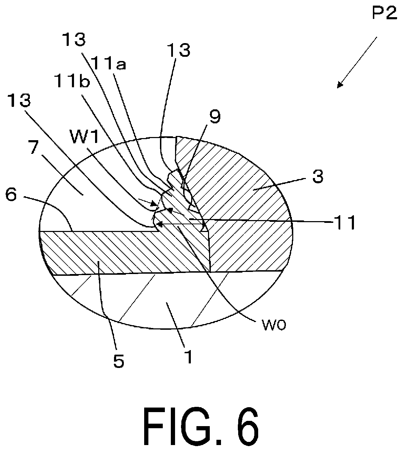

FIG. 5 is a cross-sectional view illustrating a modification example of the light emitting element mounting package illustrated in FIG. 2. FIG. 6 is an enlarged cross-sectional view of a portion P2 in FIG. 5. FIGS. 5 and 6 are cross-sectional views of the protruding portion 11 having a surface with recesses and protrusions. The reference sign of the light emitting element mounting package illustrated in FIG. 5 is B.

The protruding portion 11 may have a structure in which metal particles 13 are connected together. The structure in which the metal particles 13 are connected together is hereinafter referred to as a connected body. Furthermore, a portion smaller than the size of the metal particle 13 may be referred to as a neck portion. In the connected body of the metal particles 13, the surface of the protruding portion 11 is uneven. That is, the surface of the protruding portion 11 has recesses and protrusions.

Here, the surface of the protruding portion 11 having recesses and protrusions refers to a shape in which a width W1 between the position of the bottom of a recess 11a and the position of the top of a protrusion 11b is 1/5 or more of a maximum width W0 of the protruding portion 11. Here, the protrusions and recesses of the surface of the protruding portion 11 are determined by measuring the surface roughness of the surface of the protruding portion 11 from a substrate 1 side to the tip of the protruding portion 11. The flat portion 6 of the metal layer 5 preferably has a film shape. The surface roughness (Ra) of the flat portion 6 is preferably 1/10 or less of that of the protruding portion 11. Note that the surface roughness (Ra) of the metal layer 5 illustrated in FIGS. 1, 2, and 3, in both the flat portion 6 and the protruding portion 11, is equivalent to the surface roughness (Ra) of the flat portion 6 illustrated in FIGS. 5 and 6.

The recesses and protrusions of the surface of the protruding portion 11 make a portion of the protruding portion 11 prone to deformation. It is assumed that the thermal expansion coefficient differs between the metal layer 5 and the insulating layer 3, and that a strain is generated between the metal layer 5 and the insulating layer 3 due to a variation in the ambient temperature. The protruding portion 11 is formed of a metal. The protruding portion 11 is malleable. Thus, the protruding portion 11 includes a portion prone to deformation. This makes the protruding portion 11 less prone to breakage even with the protruding portion 11 connected to the flat portion 6 of the metal layer 5 and adhered to the insulating layer 3. That is, the recesses and protrusions of the surface of the protruding portion 11 make the protruding portion 11 partially adaptable to deformation caused by a difference in thermal expansion coefficient between the metal layer 5 and the insulating layer 3. This suppresses peeling of the protruding portion 11 from the flat portion 6 and the insulating layer 3 of the metal layer 5. As the protruding portion 11 is unlikely to be broken, the metal layer 5 including the protruding portion 11 does not easily peel from the insulating layer 3. As the insulating layer 3 does not easily peel from the metal layer 5 including the protruding portion 11, the insulating layer 3 does not easily peel from the substrate 1.

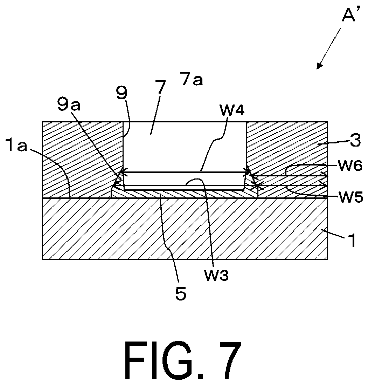

FIG. 7 is a cross-sectional view for explaining a variation in the width of the through hole in a height direction of the light emitting element mounting package A illustrated in FIG. 2. The reference sign of the light emitting element mounting package illustrated in FIG. 7 is A'. FIG. 7 illustrates an example of the light emitting element mounting package A illustrated in FIG. 2, with an enlarged view of an inclined surface 9a provided for convenience, highlighting the difference in width in the height direction of the through hole. In the light emitting element mounting package A' illustrated in FIG. 7, a width W3 of the through hole 7 closer to the surface 1a of the substrate 1 is larger than a width W4 of the through hole 7 farther from the surface 1a of the substrate 1. That is, in the light emitting element mounting package A', as illustrated in FIG. 7, the inner wall 9 of the insulating layer 3 may be inclined such that the through hole 7 becomes wider closer to the surface 1a of the substrate 1. The inner wall 9 has a portion that is inclined such that the through hole 7 becomes wider closer to the surface 1a of the substrate 1, and the portion may be referred to as the inclined surface 9a below. The inner wall 9 of the insulating layer 3 has a shape that gradually rises toward a center portion 7a side of the through hole 7 in a direction from a location close to the surface 1a of the substrate 1 toward an upper side. In FIG. 7, the width W3 of the through hole 7 is largest from the surface of the metal layer 5 to the substrate 1. In a configuration in which the through hole 7 becomes wider the closer the inner wall 9 of the insulating layer 3 is to the surface 1a of the substrate 1 (a configuration in which the inner wall 9 is partially inclined), a width W5 of the insulating layer 3 closer to the surface 1a of the substrate 1 is smaller than a width W6 of the insulating layer 3 farther from the surface 1a of the substrate 1.

That is, on an inclined surface where the inner wall 9 of the insulating layer 3 is inclined closer to the surface 1a of the substrate 1, the thickness of the protruding portion 11 on the substrate 1 side increases, which increases the rigidity of the protruding portion 11, in particular, the rigidity thereof on the substrate 1 side where the stress increases. This facilitates suppression of deformation of the insulating layer 3 and of peeling of the insulating layer 3 from the substrate 1.

Also, since the thickness of the protruding portion 11 increases on an outer side (insulating layer 3 side), the width of the insulating layer 3, that is, the bonding width between the insulating layer 3 and the substrate 1 decreases, and thus deformation due to the thermal stress of the insulating layer 3 decreases. Further, since the thickness of the protruding portion 11 increases on the outer side, the mounting region of the element on the inner side does not decrease or increase.

In such a configuration of the insulating layer 3 including the through hole 7, the width W5 of the insulating layer 3 closer to the surface 1a of the substrate 1 is smaller than the width W6 thereof farther from the surface 1a of the substrate 1, and this reduces the area of contact between the insulating layer 3 and the surface 1a of the substrate 1. This further reduces the amount of strain generated between the substrate 1 and the insulating layer 3. Thus, the insulating layer 3 is less likely to peel from the substrate 1. In this case, the protruding portion 11 is preferably disposed in contact with the inclined surface 9a. The protruding portion 11 may also be thicker closer to the surface 1a of the substrate 1, and thinner farther from the surface 1a of the substrate 1. As in the case of the portion P1 illustrated in FIG. 3, a thickness t1 closer to the surface 1a of the substrate 1 is preferably larger than a thickness t2 farther from the surface 1a of the substrate 1. That is, the protruding portion 11 preferably has a triangular shape when the light emitting element mounting package A or A' is viewed in a longitudinal cross section. Here, "triangular shape" includes not only a regular triangular shape but also a triangular shape including a somewhat round corner or a somewhat wavy side. As illustrated in FIGS. 3 and 7, the protruding portion 11 having the triangular shape in a cross-sectional view becomes thinner farther from the surface 1a of the substrate 1. As the thickness of the protruding portion 11 is partially reduced, the rigidity of the protruding portion 11 is partially reduced. The protruding portion 11 thus has a portion having partially reduced rigidity, and the portion having reduced rigidity is easier to deform. Accordingly, the protruding portion 11 is partially more adaptable to the movement of the inner wall 9 (in this case, the inclined surface 9a) of the insulating layer 3. The protruding portion 11 is less prone to peeling from the insulating layer 3. Thus, the insulating layer 3 is less prone to peeling from the surface 1a of the substrate 1. Note that the protruding portion 11 even with a surface having recesses and protrusions is less prone to peeling, provided that the outer shape thereof can be viewed as a triangle.

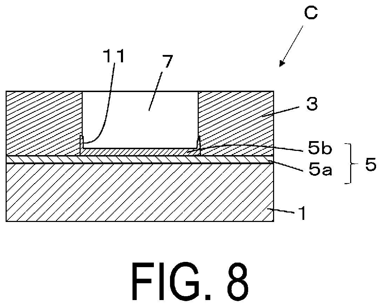

FIG. 8 is a cross-sectional view illustrating a modification example of the light emitting element mounting package illustrated in FIG. 2. The reference sign of the light emitting element mounting package illustrated in FIG. 8 is C. As illustrated in FIG. 8, the light emitting element mounting package C may include the metal layer 5 that is constituted by the first metal layer 5a and the second metal layer 5b. The first metal layer 5a and the second metal layer 5b may be layered. The first metal layer 5a and the second metal layer 5b may overlap with each other. As illustrated in FIG. 8, the metal layer 5 includes the first metal layer 5a located on the substrate 1 side and the second metal layer 5b covering the surface of the first metal layer 5a. The first metal layer 5a and the second metal layer 5b may be such that an interface therebetween can be observed, or may be such that the main constituent of each may be differentiated by elemental analysis. Here, the main constituent refers to, for example, the constituent having the highest content among the elements detected in elemental analysis of the first metal layer 5a. For example, the first metal layer 5a, which includes zinc, includes nickel as the main constituent, and the second metal layer 5b, which includes at least one element of palladium and gold, includes nickel as the main constituent. As illustrated in FIG. 8, the second metal layer 5b is in contact with the inner wall 9 of the through hole 7. That is, in the light emitting element mounting package C illustrated in FIG. 8, the protruding portion 11 is constituted by the second metal layer 5b. In the second metal layer 5b forming the protruding portion 11, the metal that forms the protruding portion 11 is nickel containing at least one element of palladium and gold.

For example, if zinc is compared with palladium or gold, palladium or gold is less likely to be oxidized than zinc. Thus, nickel containing at least one element of palladium and gold is less likely to be oxidized than nickel containing zinc. To enhance the weather resistance of the metal layer 5, a metal layer of nickel containing at least one element of palladium and gold is preferably exposed to the surface. Here, the weather resistance includes the oxidation resistance of the metal.

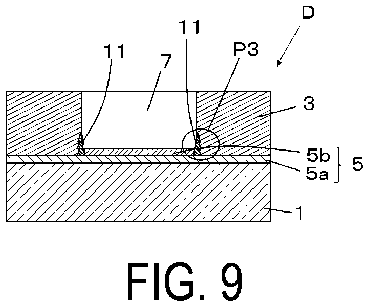

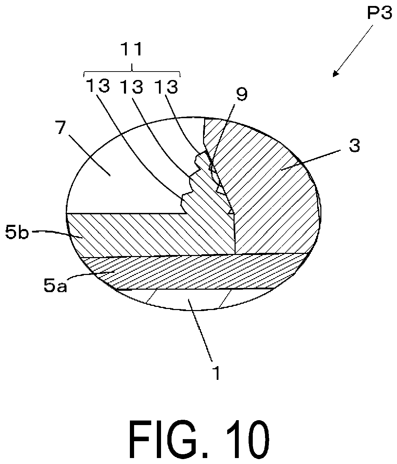

FIG. 9 is a cross-sectional view illustrating a modification example of the light emitting element mounting package illustrated in FIG. 8. FIG. 10 is an enlarged cross-sectional view of a portion P3 in FIG. 9. The reference sign of the light emitting element mounting package illustrated in FIG. 9 is D. The light emitting element mounting package D illustrated in FIGS. 9 and 10 includes the protruding portion 11 formed by the second metal layer 5b. The protruding portion 11 is a connected body of the metal particles 13. As illustrated in FIGS. 9 and 10, even in the protruding portion 11 formed by any one of a plurality of metal layers, it goes without saying that the metal layer 5 is unlikely to peel from the insulating layer 3, as in the case of the light emitting element mounting package B illustrated in FIGS. 5 and 6. In this case as well, the metal particles 13 forming the protruding portion 11 include nickel as the main constituent, and preferably include, in addition, at least one element of palladium and gold. Here, the main constituent refers to an element having the highest element count when the elemental analysis of the metal particles 13 is performed.

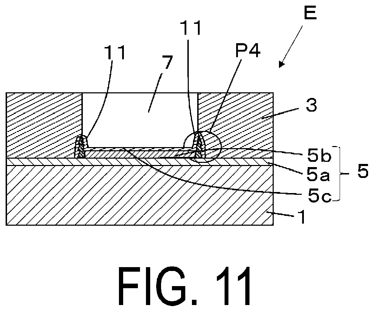

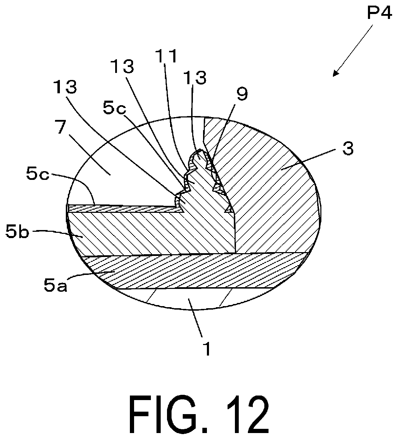

FIG. 11 is a cross-sectional view illustrating a modification example of the light emitting element mounting package illustrated in FIG. 9. FIG. 12 is an enlarged cross-sectional view of a portion P4 in FIG. 11. The reference sign of the light emitting element mounting package illustrated in FIG. 11 is E. The light emitting element mounting package E includes a third metal layer 5c provided on a surface of the second metal layer 5b. The metal layer 5 forming the light emitting element mounting package E includes the first metal layer 5a, the second metal layer 5b, and the third metal layer 5c. In this case, the second metal layer 5b may have a shape of a connected body of the metal particles 13. Here, the third metal layer 5c is preferably covered with the metal particles 13, which form the second metal layer 5b, in a state in which the metal particles 13 are connected together in the form of a neck portion. Furthermore, in the case of the light emitting element mounting package E, the metal particles 13 forming the protruding portion 11 may be connected together via the third metal layer 5c. In this case, Au or Pd or an alloy thereof is preferable as the metal of the third metal layer 5c in terms of further enhancing weather resistance. Here, the average thickness of the third metal layer 5c is preferably smaller than the average thickness of the second metal layer 5b. The average thickness of the third metal layer 5c is preferably 1/5 or less of the average thickness of the second metal layer 5b. With the third metal layer 5c too thick, the connected body formed by the second metal layer 5b is less likely to be deformed. Note that a scanning electron microscope including an analyzer, for example, is preferably used to measure the average thicknesses of the first metal layer 5a, the second metal layer 5b, and the third metal layer 5c for an analysis of the constituents constituting the metal layer 5.

In this case, the average thickness of each of the metal layers is measured as follows. First, a specific region where the first metal layer 5a, the second metal layer 5b, and the third metal layer 5c can be viewed simultaneously is selected from the cross section of the light emitting element mounting package. Next, for each of the metal layers, the thicknesses of a plurality of locations, which have been analyzed for the identification of the main constituent, are measured, and the average value thereof is determined. In this case, the plurality of locations are a plurality of positions that are set at approximately equal intervals in a given range. Preferably, three to ten locations are measured.

In this case, the second metal layer 5b may be covered by the third metal layer 5c, the layers forming a layered structure. Even in such a case, the average thickness of the third metal layer 5c is smaller than the average thickness of the second metal layer 5b. Thus, the protruding portion 11 formed by the second metal layer 5b and the third metal layer 5c remains easy to deform. This can suppress peeling of the insulating layer 3 from the substrate 1 even in a configuration in which the second metal layer 5b is covered by the third metal layer 5c, as in the light emitting element mounting packages A to D described above. Furthermore, the protruding portion 11 preferably includes a neck portion, with the distance between the metal particles 13 being smaller than the maximum diameter of the metal particles 13. That is, the protruding portion 11 preferably has a narrow portion.

Here, the above-described light emitting element mounting packages A, A', B, C, D, and E may include the metal layer 5 or the first metal layer 5a across the entirety of the surface 1a of the substrate 1 excluding a peripheral edge portion thereof or across the entirety of the surface 1a of the substrate 1. For example, as illustrated in FIG. 8, in a configuration in which the metal layer 5 or the first metal layer 5a is provided across the entirety of the surface 1a of the substrate 1 excluding the peripheral edge portion thereof or across the entirety of the surface 1a of the substrate 1, the protruding portion 11 is formed on the first metal layer 5a. Then, the insulating layer 3 is in contact with the first metal layer 5a and the protruding portion 11, both of which are made of a metal.

The light emitting element mounting package A illustrated in FIG. 2 has a structure in which the insulating layer 3 contacts two members, the substrate 1 and the protruding portion 11 made of a metal. In contrast to the light emitting element mounting package A illustrated in FIG. 2, the light emitting element mounting package C illustrated in FIG. 8 deforms or moves with the insulating layer 3 in contact with the first metal layer 5a and the protruding portion 11, both of which are made of a metal. In the case of the light emitting element mounting package C illustrated in FIG. 8, the insulating layer 3 is not in contact with the two types of members, the substrate 1 and the protruding portion 11 made of a metal, as in the light emitting element mounting package A illustrated in FIG. 2. The insulating layer 3 in the light emitting element mounting package C is in contact with one type of material (metal). The insulating layer 3 in the light emitting element mounting package C is not susceptible to effects caused by the physical properties of the substrate 1 (Young's modulus and thermal expansion coefficient), and thus the amount of deformation generated in the insulating layer 3 can be reduced more than in the light emitting element mounting package A illustrated in FIG. 2. In this case, when the first metal layer 5 and the substrate 1 are compared in terms of Young's modulus, the Young's modulus of the first metal layer 5 is preferably lower than the Young's modulus of the substrate 1.

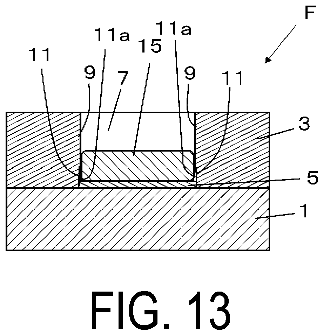

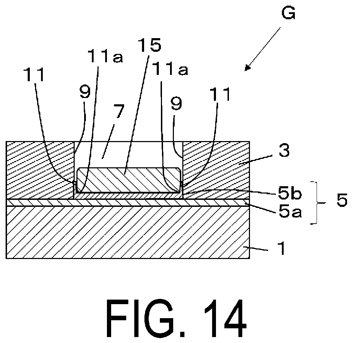

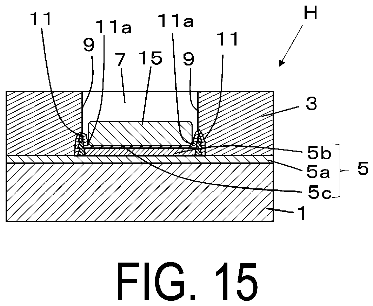

FIGS. 13, 14, and 15 are each a cross-sectional view illustrating another aspect of the light emitting element mounting package. FIG. 13 illustrates a light emitting element mounting package F, which is the light emitting element mounting package A described above with a submount substrate 15 disposed in the through hole 7. FIG. 14 illustrates a light emitting element mounting package G, which is the light emitting element mounting package C described above with the submount substrate 15 disposed in the through hole 7. FIG. 15 illustrates a light emitting element mounting package H, which is the light emitting element mounting package E described above with the submount substrate 15 disposed in the through hole 7. The light emitting element mounting package F illustrated in FIG. 13, the light emitting element mounting package G illustrated in FIG. 14, and the light emitting element mounting package H illustrated in FIG. 15 each include the submount substrate 15 on the metal layer 5 provided in the through hole 7 of the insulating layer 3. In the light emitting element mounting packages F, G, and H, the metal layer 5 provided in the through hole 7 includes the protruding portion 11 on the substrate 1 side of the inner wall 9 of the through hole 7. Thus, the submount substrate 15 is disposed on an inner side of the protruding portion 11. The protruding portion 11 provided on each of the light emitting element mounting packages F, G, and H has a cross section that spreads out in a skirt-like fashion in a thickness direction from the insulating layer 3 side toward the substrate 1 side. Thus, the submount substrate 15 is fitted between the skirt portions of the protruding portion 11. That is, the submount substrate 15 is partially not in contact with the insulating layer 3.

In this case, the submount substrate 15 is preferably a strong ceramic such as silicon nitride, aluminum nitride, or alumina. When a light emitting element mounted on the submount substrate 15 emits light, the temperature of the light emitting element mounting package rises above ambient temperature. In such a case, the submount substrate 15 is less susceptible to deformation of the insulating layer 3 even when the insulating layer 3 deforms due to thermal expansion or the like. Thus, the light emitting element mounting packages F, G, and H, even when thermally deformed, can suppress peeling of the insulating layer 3 from the substrate 1. Furthermore, the light emitting element mounting packages F, G, and H can enhance the positional accuracy of the submount substrate 15 even when the light emitting element keeps turning on and off. Note that in the light emitting element mounting packages F, G, and H, a bonding material such as solder may be provided between the metal layer 5 and the submount substrate 15, provided that the positional accuracy of the submount substrate 15 remains effectively intact. That is, the submount substrate 15 may be installed on the metal layer 5 via a bonding material such as solder. The bonding material is preferably one selected from the group of Au-Sn, silver solder, solder (Sn-Pb), organic resin, and the like.

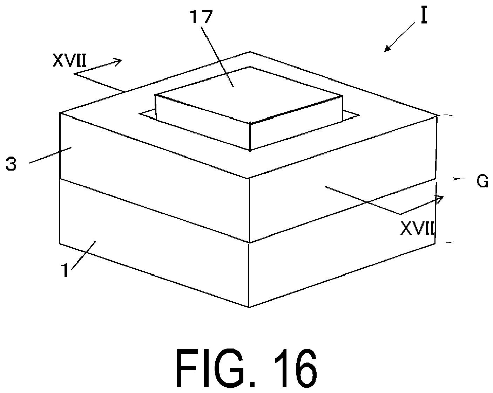

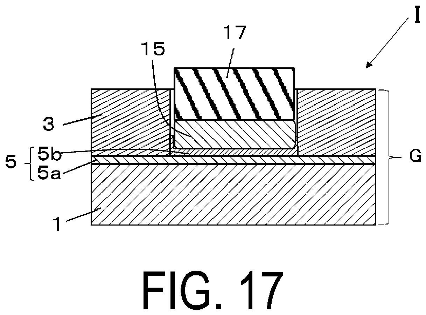

FIG. 16 is an exterior perspective view of a light emitting device as an example of an embodiment. FIG. 17 is a cross-sectional view taken along line XVII-XVII in FIG. 13. A light emitting device I illustrated in FIGS. 16 and 17 uses the light emitting element mounting package G described above as an example of a light emitting element mounting package. The light emitting device I includes a light emitting element 17 mounted in the light emitting element mounting package G. In this case, the light emitting element 17 is mounted on the submount substrate 15. Examples of methods of mounting the light emitting element 17 in the light emitting element mounting package G include a flip-chip method and a wire bonding method. Examples of the light emitting element 17 include a laser diode (LD) in addition to an LED element. A plurality of the light emitting elements 17 may be mounted in the light emitting element mounting package G. In such a case, the flip-chip method, which can enhance the integration degree of the light emitting elements 17, is preferably used. The light emitting device I, which includes the light emitting element mounting package G having a structure that suppresses peeling of the insulating layer 3 from the substrate 1, is a reliable light emitting device. Furthermore, the light emitting device I has stability in the directionality and luminosity of light emitted due to the use of the light emitting element mounting package F, G, or H having high positional accuracy of the submount substrate 15. Here, the light emitting device I is illustrated only as an example of an embodiment. It goes without saying that other aspects of the light emitting element mounting package may be applied. Examples of other aspects of the light emitting element mounting package include the light emitting element mounting packages A to F and the light emitting element mounting package H.

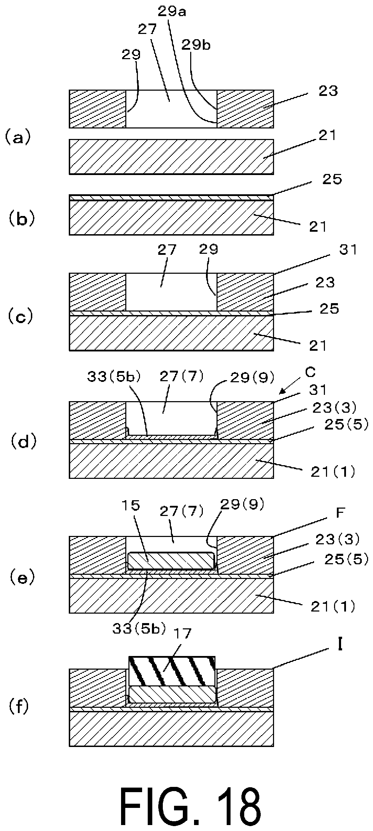

FIG. 18 is a cross-sectional view of a method of manufacturing a light emitting device as an example of an embodiment. The method of manufacturing the light emitting device illustrated in FIG. 18 is an example of a method of manufacturing the light emitting device I illustrated in FIGS. 16 and 17. As illustrated in (a) of FIG. 18, the first step is to prepare a metal plate 21 and an organic resin sheet 23. The metal plate 21 is a material for obtaining the substrate 1. The organic resin sheet 23 is a material for obtaining the insulating layer 3. As illustrated in (a) of FIG. 18, the metal plate 21 and the organic resin sheet 23 are each machined into a predetermined shape. The organic resin sheet 23 includes a hole 27, which is to be the through hole 7 of the insulating layer 3. The hole 27 may be formed by, in addition to punching with a metal mold, using a laser machining apparatus. For a hole 27 having a size that is equal to or greater than a predetermined size, a metal mold is preferably used. The organic resin sheet 23 is machined so that the surface roughness of an inner wall 29 of the hole 27 in a portion 29a closer to the surface of a side that is adhered to the metal plate 21 (substrate 1) is greater than the surface roughness of a center portion 29b in a thickness direction of the organic resin sheet 23. Here, the inner wall 29 of the hole 27 corresponds to the inner wall 9 of the through hole 7. To machine the inner wall 29 of the hole 27 formed in the organic resin sheet 23 into a different state of surface roughness as described above, the speed at which the hole 27 is formed by punching the organic resin sheet 23 using a metal mold may be varied, for example. The variation in speed during the formation of the hole 27 by punching is caused by making the speed at which the metal mold passes through the portion 29a closer to the surface of the organic resin sheet 23 slower than the speed at which the metal mold passes through the center portion 29b in the thickness direction of the organic resin sheet 23. When the hole 27 is formed in the organic resin sheet 23 under such conditions, the surface roughness of the inner wall 29 of the hole 27 in the portion 29a of the organic resin sheet 23 closer to the surface of the side that is adhered to the metal plate 21 (substrate 1) is greater than the surface roughness of the center portion 29b in a thickness direction of the inner wall 29. In this case, a plating film is easily formed on a portion having a rough surface on the inner wall 29, and the protruding portion 11 can be formed. The speed at which the hole 27 is formed by punching into the organic resin sheet 23 is the speed at which the metal mold passes through the center portion 29b in the thickness direction described above. When the speed at which the hole 27 is formed is set to such conditions, the surface roughness of the portion 29a of the organic resin sheet 23 closer to the surface of the side that is adhered to the metal plate 21 (substrate 1) is close to the surface roughness of the center portion 29b in the thickness direction of the organic resin sheet 23. The surface roughness of the inner wall 29 of the hole 27 formed under such conditions is equivalent to the surface roughness of the center portion 29b in the thickness direction described above.

Furthermore, the metal plate 21 is cut and machined from a metal block into the shape of the substrate 1. The metal plate 21 is preferably obtained by machining such as dicing using a mechanical cutter. When the metal plate 21 is obtained by machining using a mechanical cutter, recesses and protrusions are easily formed on the surface of the metal plate 21 thus obtained. The recesses and protrusions formed on the surface of the metal plate 21 enable the organic resin sheet 23 to be firmly adhered to the surface of the metal plate 21.

Next, as illustrated in (b) of FIG. 18, a first metal film 25, which is to be the first metal layer 5a, is formed on the metal plate 21. The first metal film 25 is produced by electrolytic plating using a plating solution containing a specific metal constituent. For example, if aluminum is used for the metal plate 21, a plating solution containing zinc and nickel is used. When aluminum is used for the metal plate 21, and a plating solution containing zinc and nickel is used, the aluminum included in the metal plate 21 is first replaced with zinc, and then nickel is deposited via the zinc. Thus, the first metal film 25 (first metal layer 25a) containing nickel as the main constituent is formed on the surface of the metal plate 21.

Next, as illustrated in (c) of FIG. 18, the organic resin sheet 23 is adhered to the surface of the metal plate 21 on which the first metal film 25 is formed to form a laminated body 31. The metal plate 21 and the organic resin sheet 23 are adhered by a laminating machine that can apply pressure while being heated. The conditions for pressurized heating are set such that the cross section of the through hole 7 formed in the organic resin sheet 23 deforms. Thus, an inclined portion can be formed on the inner wall 29 of the hole 27 formed in the organic resin sheet 23. The cross section of the through hole 7 may be deformed to such an extent that the inner wall 29 of the hole 27 curves or bends in the portion 29a closer to the surface of one side of the organic resin sheet 23. When the organic resin sheet 23 is adhered onto the metal plate 21, the adhering surface between the organic resin sheet 23 and the metal plate 21 is unlikely to move. Other portions of the organic resin sheet 23 in the thickness direction away from the adhering surface deform thermoplastically. Such properties of the organic resin sheet 23 are used to deform the cross section of the hole 27 formed in the organic resin sheet 23. Thus, the shape of the cross section of the hole 27 can constitute the laminated body 31 as illustrated in FIGS. 3 or 6. That is, a shape in which the inner wall 9 of the through hole 7 provided in the insulating layer 3 includes the inclined surface 9a can be obtained. The shape of the cross section of the hole 27 formed in the organic resin sheet 23 can be changed by changing the viscoelastic properties of the organic resin sheet 23, the heating temperature of the laminating machine, and the pressurizing conditions of the laminating machine. An organic resin sheet including an inclined portion (C chamfer) on the inner wall 29 of the hole 27 may be used as the organic resin sheet 23.

Next, as illustrated in (d) of FIG. 18, a second metal film 33, which is to be the second metal layer 5b, is formed on the surface of the first metal film 25 in the hole 27 formed in the organic resin sheet 23 forming the laminated body 31. For the formation of the second metal film 33, an electroless plating method or an electroplating method is used. First, a plating film is formed on the surface of the first metal film 25 by an electroless plating method. The plating film is also formed then in the portion 29a of the organic resin sheet 23 closer to the surface of the inner wall 29 of the hole 27. The plating film is more likely to be formed using the electroless plating method in a portion where the surface roughness of the inner wall 29 of the hole 27 is large than in other flat portions. Thereafter, a plating film is further formed by the electroplating method on the surface of the plating film formed by the electroless plating method. Thus, the second metal film 33, which is to be the second metal layer 5b, can be formed on the surface of the first metal film 25 in the organic resin sheet 23. Here, the portion 29a of the inner wall 29 of the hole 27 closer to the surface of the organic resin sheet 23 is rougher than the center portion 29b in the thickness direction of the inner wall 29. Furthermore, the portion having the rough surface on the inner wall 29 of the hole 27 partially curves or bends during the layering. Thus, the protruding portion 11 is formed facing the portion partially curved or bent on the inner wall 29 of the hole 27. In this case, the protruding portion 11 is formed by a plating film forming the second metal film 33. Note that the protruding portion 11 can be formed into a connected body of the metal particles 13 by, for example, setting the current value during the execution of the electroplating method to 2/3 or less of the normal current value. The second metal film 33 may constitute a connected body of the metal particles 13, the connected body including a neck portion. In such a case, a third metal film, which is to be the third metal layer 5c, may be further formed. (d) of FIG. 18 illustrates an example of the light emitting element mounting package C, but the light emitting element mounting packages D, E can be obtained by employing different manufacturing conditions.

Next, as illustrated in (e) of FIG. 18, the submount substrate 15 is installed in the through hole 7 formed in the light emitting element mounting package C. Thus, the light emitting element mounting packages F, G, and H can be obtained from the light emitting element mounting packages C, D, and E, respectively. The submount substrate 15 may be bonded directly to the second metal film 33 or the third metal film by applying energy such as ultrasonic waves to the surface of the second metal film 33, or may be bonded via a bonding material such as solder.

Next, as illustrated in (f) of FIG. 18, the light emitting element 17 is mounted on the submount substrate 15 installed in the light emitting element mounting package G. Thus, the light emitting device I can be obtained.

### Examples

A light emitting element mounting package was actually produced and evaluated for reliability. The light emitting element mounting package G (sample 1) illustrated in FIG. 14 and the light emitting element mounting package H (sample 2) illustrated in FIG. 15 were produced as the light emitting element mounting packages using the manufacturing method described above. Aluminum was used as the substrate. An epoxy resin containing 30% by volume of silica particles was used as the insulating layer. The first metal layer was formed by an electroplating method using a plating solution of nickel containing zinc. The second metal layer was formed by an electroless plating method and an electroplating method using a plating solution of nickel after palladium activation treatment. The third metal layer was formed by an electroplating method using a plating solution of palladium and gold. The conditions for pressurized heating during the production of the laminated body were set to a temperature of 80°C and a pressure of 5 MPa. The laminated body that was subjected to pressurized heating was then subjected to heat treatment at a temperature of 200°C for a holding time of 3 hours.

Furthermore, a light emitting element mounting package including the metal layer with no protruding portion was produced as a Comparative Example (Sample 3). The speed in the thickness direction during the formation of the hole in the resin sheet by punching was kept constant during the production of the light emitting element mounting package including the metal layer with no protruding portion, the light emitting element mounting package serving as the sample 3. The surface roughness of the inner wall of the hole was set to a level corresponding to the surface roughness of the center portion in the thickness direction of the resin sheet in the sample 1 and the sample 2. Furthermore, pressurized heating was performed under more moderate conditions during the adhesion of the metal plate and the resin sheet, thus preventing the cross section of the through hole from bending. The conditions for pressurized heating were set to a temperature of 40°C and a pressure of 0.5 MPa. In this case as well, the laminated body that was subjected to pressurized heating was then subjected to heat treatment at a temperature of 200°C for a holding time of 3 hours.

In the light emitting element mounting package thus produced, the planar surface area of the substrate and that of the insulating layer were each 40 mm × 40 mm; the surface area of the through hole provided in the insulating layer was 20 mm × 20 mm, and the thickness thereof was 1 mm; the thickness of the metal plate (substrate) was 0.7 mm; and the thickness of the insulating layer was 0.3 mm. A temperature cycle test was used as a reliability test. The conditions for the temperature cycle test were set to a minimum temperature of -55°C and a maximum temperature of 150°C. The holding time at the minimum temperature, the holding time at the maximum temperature, and the time it took for the temperature to change from the minimum temperature to the maximum temperature or vice versa were each 15 minutes. The number of temperature cycles was set to 3000 times and 3500 times. The number of samples was 10 of each. The post-test evaluation was judged to be pass/fail based on whether or not a peeled portion was found between the substrate and the insulating layer. The state of peeling between the substrate and the insulating layer was confirmed by a method in which the substrate and the insulating layer were immersed in a red check liquid. Samples in which penetration of the red check liquid was observed between the insulating layer and the substrate on the inner wall side of the through hole were determined to be defective. No difference was observed in the peeling state between the substrate and the insulating layer among the 10 samples of each of the sample 1, the sample 2, and the sample 3. The test revealed that none of the samples of the sample 1 and sample 2 had peeling between the substrate and the insulating layer after 3000 cycles. Some of the samples of the sample 1 had peeling at 3500 times. None of the samples of the sample 2 were defective at 3500 times. All of the samples of the sample 3 were determined to be defective after 3000 cycles.

### Reference Signs List

1 Substrate
3 Insulating layer
5 Metal layer
5a First metal layer
5b Second metal layer
5c Third metal layer
6 Flat portion
7 Through hole
9 Inner wall
11 Protruding portion
13 Metal particle
15 Submount substrate
17 Light emitting element

## Claims

1. A light emitting element mounting package, comprising:
a substrate;
an insulating layer; and
a metal layer, wherein
the insulating layer comprises a through hole penetrating in a thickness direction and is disposed on the substrate, and
the metal layer is disposed on the substrate in at least the through hole and has a protruding portion extending from the substrate along an inner wall of the through hole.

2. The light emitting element mounting package according to claim 1, wherein
the protruding portion is disposed to encircle the inner wall.

3. The light emitting element mounting package according to claim 1 or 2, wherein
the protruding portion comprises recesses and protrusions on a surface thereof.

4. The light emitting element mounting package according to any one of claims 1 to 3, wherein
the inner wall comprises, closer to the substrate, an inclined surface where the through hole becomes wider, and
the protruding portion contacts the inclined surface.

5. The light emitting element mounting package according to any one of claims 1 to 4, wherein
the metal layer comprises a first metal layer and a second metal layer, and
the second metal layer overlaps the first metal layer and forms the protruding portion.

6. The light emitting element mounting package according to any one of claims 1 to 5, further comprising:
a submount substrate for mounting a light emitting element on the metal layer in the through hole.

7. A light emitting device, comprising:
a light emitting element on the metal layer of the light emitting element mounting package according to any one of claims 1 to 6.
